# EUROPÄISCHE PATENTSCHRIFT

(11) **EP 3 161 180 B1**
(45) Veröffentlichungstag und Bekanntmachung des Hinweises auf die Patenterteilung: **06.02.2019**
(21) Anmeldenummer: 15741114.1
(22) Anmeldetag: 26.06.2015
(51) Int. Cl.: C23C 14/34, H01J 37/34, C23C 14/35, C23C 14/06

(54) **SPUTTERING TARGET**
SPUTTERING TARGET
CIBLE DE PULVERISATION CATHODIQUE

(30) Priorität: 27.06.2014 US 201462017909 P
(43) Veröffentlichungstag der Anmeldung: 03.05.2017
(73) Patentinhaber: PLANSEE COMPOSITE MATERIALS GMBH, DE-86983 Lechbruck am See (DE); Oerlikon Surface Solutions AG, Pfäffikon, 8808 Pfäffikon (CH)
(72) Erfinder: POLCIK, Peter, 6600 Reutte (AT); WÖRLE, Sabine, 6600 Pflach (AT); KRASSNITZER, Siegfried, 6800 Feldkirch (AT); HAGMANN, Juerg, 9468 Sax (CH)
(74) Vertreter: Ciesla, Bettina
(86) Internationale Anmeldenummer: PCT/EP2015/001298
(87) Internationale Veröffentlichungsnummer: WO 2015/197196

(56) Entgegenhaltungen:
- JP-A- S62 278 261
- JP-A- S63 241 167

## Beschreibung

Die Erfindung betrifft ein Target, welches insbesondere als Sputtering Target für die Anwendung höchster Leistungsdichten während des Sputtern des Targets geeignet ist und ein Verfahren zu dessen Herstellung.

Erfindungsgemäße Targets können in vielen unterschiedlichen physikalischen Gasphasenabscheidungsprozessen (üblicherweise und auch im Folgenden auch PVD-Prozesse genannt: physical vapour deposition processes), mit deren Hilfe Schichten aus der Gasphase abgeschieden werden, zum Einsatz kommen, wie beispielsweise das Lichtbogenverdampfen oder auch das Zerstäuben (bereits oben und im Folgenden auch Sputtern bzw. Sputtering genannt). Insbesondere betrifft die Erfindung daher nicht nur, aber in besonderer Weise Sputtering Targets wie sie in einem PVD Sputterprozess zur Abscheidung von Schichten auf ein dafür vorgesehenes Substratmaterial verwendet werden.

In den letzten Jahren kommen zunehmend Sputtering Targets zur Anwendung, die aus spröden Werkstoffen bestehen oder spröde Werkstoffe enthalten. Die Verwendung von Sputtering Targets welche in eine Gruppe von Materialien, welche als spröde bezeichnet werden, einzuordnen sind, stellt eine große Herausforderung beim Sputtern dar. Insbesondere die Aufbringung hoher Sputterleistungen bzw. hoher Sputterleistungsdichten erfordert eine sehr gute Kühlung, um thermisch induzierten mechanischen Stress, bzw. Spannungen die zum Bruch des Targets führen können, zu vermeiden.

Als spröde werden im Rahmen dieser Beschreibung diejenigen Werkstoffe angesehen, die nahe der Elastizitätsgrenze ohne oder mit nur geringer plastischer Verformung brechen. Diese Werkstoffe und damit auch die daraus hergestellten Sputtering Targets haben also nur ein geringes plastisches Verformungsvermögen.

Deshalb sind solche Sputtering Targets zum einen relativ schlecht durch Zerspannung zu bearbeiten und es ist sehr schwierig komplizierte Geometrien, die jedoch für den Einbau in diverse verschiedene Beschichtungsanlagen erforderlich sein können, zu realisieren. Eine Bearbeitung ist somit oft nur mehr über Schleifen und Drahterodieren möglich, dies hat jedoch wieder um zur Folge, dass nur einfache Geometrien (Ronden, Platten) fertigbar sind.

Solche Targets werden während ihres Einsatzes als Sputtering Targets in einer Beschichtungsanlage mechanischen und thermomechanischen Belastungen ausgesetzt, die zu Biege- und/oder Zugspannungen führen. Bei spröden Werkstoffen führen diese Spannungen oft zum Versagen durch Bruch, da das Verformungsvermögen gering ist. Die mechanischen und thermomechanischen Belastungen können zum einen aus dem Druck des Kühlwassers auf die Rückseite des Targets und/oder zum anderen aus der Ausdehnung des Materials aufgrund der thermischen Leistung die während des Sputterprozesses in das Sputtering Target eingebracht wird resultieren. Durch diese teilweise nur lokal eingebrachte thermische Leistung können auch Spannungen entstehen, die aus lokalen Temperaturgradienten resultieren. In Kombination mit einer oft schlechten Thermoschockbeständigkeit dieser Werkstoffe, führen diese Faktoren oft zur Entstehung von Rissen und in Folge zum Versagen des Sputtering Targets durch Bruch.

Beispiele für solche spröden Werkstoffe für Sputtering Targets sind keramische Werkstoffe, insbesondere Boride, Nitride, Karbide, Silizide, Oxide aber auch metallische spröde Werkstoffe wie Cr oder Si sowie Mischungen aus diesen Werkstoffen. Diese spröden Werkstoffe weisen meist eine plastische Bruchdehnung von kleiner gleich 2%, oft sogar kleiner gleich 0,2% auf.

Bei der Verwendung von Targets als Sputtering Targets in einer PVD Beschichtungsanlage treten wie oben erwähnt häufig hohe Temperaturen und oder große Temperaturgradienten auf, die durch die Einbringung hoher Leistungsdichten von > 10W/cm² verursacht werden. Solcherart erzeugte Temperaturen bzw. Temperaturgradienten müssen über das Sputtering Target zur Kühlplatte abgeführt werden und üben eine hohe Thermowechselbeanspruchung auf das Sputtering Target aus.

Eine effiziente Kühlung des Sputtering Targets in der PVD Beschichtungsanlage wird durch Kühlwasser ermöglicht. Üblicherweise werden in solchen PVD Beschichtungsanlagen die verwendeten Sputtering Targets über flexible Kühlplatten gekühlt die auf der Rückseite der Sputtering Targets angeordnet sind. Durch diese Kühlplatten wird, wie bereits oben erwähnt, ein Druck auf die Sputtering Targets ausgeübt, was wiederum zu einer Verformung der Sputtering Targets, oder bei zu geringer Festigkeit derselben zum Bruch führen kann. Dieser Effekt wird zusätzlich dadurch verstärkt, dass sich die Stärke des Sputtering Targets während des Sputterprozesses durch den Abtrag verringert. Dies hat zur Folge, dass es noch wahrscheinlicher zu Verformung und oder Bruch des Sputtering Targets kommen kann.

Im Allgemeinen ist die mechanische Stabilität (Festigkeit sowie Duktilität) der erwähnten Target Material Gruppe (spröde Werkstoffe) nicht ausreichend um alleinig die mechanische Belastung tragen zu können. Außerdem ist eine komplexe Formgebung, wie Löcher, Bohrungen oder Bajonette, welche die Befestigung eines Sputtering Targets in einer entsprechenden Beschichtungsanlage erfordert nur sehr schwierig und nur unter hohen Kosten herzustellen.

Deshalb ist es üblich, Targets aus spröden Werkstoffen wie beispielsweise keramische Werkstoffe, welche als Sputtering Targets verwendet werden sollen, konstruktiv mit einer Rückplatte (back plate) auszustatten. Dabei wird dann der spröde zu sputternde Werkstoff als Targetplatte ausgelegt. Die Rückplatte soll der Erhöhung der Festigkeit (Streckgrenze, Bruchfestigkeit) und Erhöhung der Duktilität (Bruchdehnung, Bruchzähigkeit) des Sputtering Targets im Vergleich mit einem Sputtering Target ohne Rückplatte dienen. Mit einer derartigen Rückplatte kann einerseits eine aufwendige Bearbeitung der Rückseite des spröden Werkstoffs des Sputtering Targets (eigentlich der Targetplatte aus sprödem Material) umgangen und zum anderen die mechanische Belastung durch den Druck des Kühlwassers reduziert werden (unter der Voraussetzung, dass der Werkstoff aus dem die Rückplatte gefertigt ist eine höhere Steifigkeit als der Werkstoff aus dem die Targetplatte gefertigt ist aufweist).

Die Festigkeit und Duktilität des Sputtering Targets werden also durch das Aufbringen einer Rückplatte gesteigert, sodass sich das Sputtering Target bei der Verwendung in einer PVD Beschichtungsanlage nicht bzw. nicht wesentlich verformt und nicht durch einen Bruch versagt. Durch das Aufbringen einer Rückplatte mit erhöhter Festigkeit bzw. Duktilität werden solche Versagensfälle weitgehend vermieden.

Die Rückplatte kann auch als Wärmesenke dienen, d.h. durch das Aufbringen einer Rückplatte mit einer im Vergleich zum Werkstoff der Targetplatte erhöhten Wärmeleitfähigkeit kann die im Sputterprozess auf der dem Substrat zugewandten Sputtering Target Seite (Vorderseite) entstehende Wärme besser über das Target abgeführt werden. Ein Beispiel für so eine Wärmesenke zeigt die EP1335995A1*.*

Die Aufbringung von Targetplatten für Sputtering Targets aus spröden Werkstoffen auf Rückplatten aus besonders steifen oder besonders gut wärmeleitfähigen Werkstoffen erfolgt üblicherweise über Bonden (auch Löten genannt). Das Bonden wird mit niedrig schmelzenden Loten auf der Basis von Indium oder Zinn durchgeführt. Entsprechende Rückplatten sind beispielsweise aus Kupfer (Werkstoff mit einer hohen thermischen Leitfähigkeit) oder Molybdän (Werkstoff mit einer hohen Steifigkeit) gefertigt.

Da das Löten von Targetplatten für Sputtering Targets auf Rückplatten bei höheren Temperaturen als Raumtemperatur durchgeführt wird sind die thermischen Ausdehnungskoeffizienten der Rückplatten üblicherweise auf jene der Targetplatten Werkstoffe angepasst. Dies führt dazu, dass Spannungen minimiert werden können, die im Werkstoffverbund des Sputtering Targets (Interface Targetplatte/Rückplatte) nach der Abkühlung von der Löttemperatur auf die Raumtemperatur entstehen.

Eine weitere Möglichkeit um Targetplatten für Sputtering Targets aus spröden Werkstoffen auf entsprechende Rückplatten aufzubringen ist Kleben mit temperaturbeständigen und sowohl elektrisch als auch thermisch leitfähigen Klebern auf Rückplatten aus z.B. Kupfer.

Alternativ können die Targetplatten für Sputtering Targets auch mechanisch auf eine entsprechende Rückplatte geklemmt werden. Dabei kann auch zusätzlich eine Zwischenfolie aus Graphit oder Silber zur Verbesserung der Wärmeleitfähigkeit zwischen die Targetplatte und die Rückplatte (z.B. aus Kupfer) geklemmt werden.

All diese Targets haben aber den Nachteil, dass sie, wenn sie als Sputtering Targets verwendet werden, bei der Verwendung von hohen Sputterleistungen bzw. Sputterleistungsdichten, die während des Sputtern des Targets in das Target eingebracht werden, versagen können. Dadurch wird die verwendbare Sputterleistung limitiert. In manchen Fällen wird durch die Einbringung hoher Leistungsdichten die Temperatur im Sputtering Target zu hoch, und infolgedessen versagt die Lot- bzw. Klebeverbindung thermisch. In anderen Fällen führt die hohe Sputterleistung wie bereits oben erwähnt zu einer Verformung oder zum Bruch des Sputtering Targets.

Die JP 63-241167 A beschreibt ein Target aus einer Legierung, wobei das Target über eine Verbindungsschicht mit einer Rückplatte verbunden ist. Um ein Ausbrechen von Targetstücken im Einsatz zu vermeiden, wird eine stängelige Kristallstruktur des Targetmaterials, bei dem die einzelnen Kristalle im Wesentlichen senkrecht zu der Ebene der Rückplatte ausgerichtet sind, vorgeschlagen. Erzeugt wird eine derart ausgerichtete stängelige Kristallstruktur, indem das Targetmaterial in eine Form gegossen und dann anisotrop entlang einer Kühlrichtung abgekühlt wird. Die JP 62-278261 A beschreibt ein Target enthaltend eine intermetallische Legierung, bei der das Target über eine Verbindungsschicht, insbesondere über eine Indiumlotschicht, mit einer Rückplatte verbunden wird. Nach dem Verbindungsschritt wird die Targetanordnung leicht erwärmt und auf der Seite des Targets einem thermischen Schock ausgesetzt, beispielsweise durch Kühlung mit flüssigem Stickstoff, wodurch eine Rissbildung in dem Target ausgelöst wird.

### Aufgabe der vorliegenden Erfindung

Es ist eine Aufgabe der vorliegenden Erfindung die Durchführung von Beschichtungsprozessen mittels Sputtern von Targets aus einem oder mehreren spröden Werkstoffen unter Verwendung von hohen Sputterleistungen bzw. hohen Sputterleistungsdichten im Vergleich mit dem Stand der Technik zu ermöglichen.

Es ist auch eine Aufgabe der vorliegenden Erfindung ein Target, welches als Sputtering Target zur Durchführung von Sputterprozessen unter Verwendung von hohen Sputterleistungen bzw. von hohen Sputterleistungsdichten verwendet werden kann, bereitzustellen. Ein solches Target soll einfach herstellbar und mechanisch und thermisch stabil sein.

Es ist weiters eine Aufgabe der vorliegenden Erfindung ein Verfahren bereitzustellen, welches eine einfache Herstellung des mechanisch und thermisch stabilen Sputtering Targets, das zur Durchführung von Sputterprozessen unter Verwendung von hohen Sputterleistungen bzw. von hohen Sputterleistungsdichten verwendet werden kann, ermöglicht.

### Beschreibung der vorliegenden Erfindung

Durch die vorliegenden Erfindung werden die oben genannten Probleme und Limitierungen behoben und ein Sputtering Target zur Verfügung gestellt, das bei hohen Sputterleistungen bzw. Leistungsdichten im Sputterprozess betrieben werden kann, ohne dass dieses zerstört und damit für eine weitere Verwendung unbrauchbar wird.

Erfindungsgemäß wird ein Sputtering Target umfassend eine Targetplatte mit Vorderseite und Rückseite aus einem spröden Material bereitgestellt, wobei die Targetplatte zumindest als Hauptbestandteil ein keramisches Material umfasst, wobei die Targetplatte mit einer Rückplatte über ein Bonding-Lot, das einen Schmelzpunkt von größer 400 °C aufweist, flächig verbunden ist und wobei die Targetplatte Mikrorisse aufweist welche von der Vorderseite zur Rückseite durchgehen und die Targetplatte in aneinander grenzende Bruchstücke aufteilt.

### Das Material der Targetplatte (Material A) weist einen höheren

Ausdehnungskoeffizienten im Vergleich mit dem Material der Rückplatte (Material B) auf. Die Targetplatte steht somit mindestens im mittleren Bereich unter Zugspannung, wodurch die Mikrorisse in der Targetplatte entstehen.

Vorzugsweise liegt dabei die Länge und Breite der Bruchstücke im Mittel in der Größenordnung der Dicke der Targetplatte.

Die Mikrorisse haben zur Folge, dass bei einer im Rahmen des Sputterprozesses eingebrachten hohen Leistungsdichte weniger Spannungen auftreten, da die Ränder der Bruchstücke sich relativ zueinander verschieben können.

Im Folgenden wird nun beispielhaft und anhand der Figuren erläutert wie ein erfindungsgemäßes Sputtering Target hergestellt werden kann. Dies wird am Beispiel eines keramischen Sputtering Targets, in diesem Fall TiB2, gebondet auf eine mechanisch stabile Rückplatte, in diesem Fall aus Molybdän, derart, dass durch den Bonding-Prozess Mikrorisse entstehen, welche zur Reduktion von mechanischen Zugspannungen führen.

Dabei sei nochmals darauf hingewiesen, dass die Verwendung von keramischen Sputtering Targets welche in eine Gruppe von Materialien, welche als spröde bezeichnet werden, einzuordnen sind, eine große Herausforderung beim Sputtern darstellt. Insbesondere die Aufbringung hoher Sputterleistung (Einbringung hoher Leistungsdichten) erfordert eine sehr gute Kühlung um thermisch induzierten mechanischen Stress (Spannungen die zum Bruch des Targets führen können) zu vermeiden. Um eine gute Kühlung gewährleisten zu können, wird das Target oft über eine flexible Membrane mit einem hohen Kühlwasserdruck beaufschlagt. Dies führt zu einer mechanischen Biegebelastung des Targets. Im Allgemeinen ist die mechanische Stabilität (Festigkeit sowie Duktilität) der erwähnten Target Material Gruppe (spröde, insbesondere keramische Sputtering Targets) nicht ausreichend, um alleinig die mechanische Belastung tragen zu können.

Außerdem ist eine komplexe Formgebung, wie Löcher, Bohrungen oder Bajonette, welche die Befestigung eines Sputtering Targets in einer entsprechenden Beschichtungsanlage erfordert, nur sehr schwierig und nur unter hohen Kosten herzustellen. Targetplatten aus der spröden (z.B. keramischen) Materialgruppe werden daher auf eine Rückplatte durch einen Bonding-Prozess (Lötprozess) fixiert.

Bevorzugte Formen eines erfindungsgemäßen Sputtering Targets sind kreisförmige bzw. rechteckige Platten, bevorzugte Dimensionen sind Durchmesser von etwa 50 bis 300 mm bzw. Abmessungen in der Größenordnung von 50 bis 1000 mm.

Das Sputtering Target kann also auf folgende Weise hergestellt werden:
- Bereitstellung einer Targetplatte, die als Hauptbestandteil ein keramisches Material umfasst
- Bereitstellung einer Rückplatte, wobei für die Rückplatte ein Material gewählt wird, welches einen kleineren thermischen Ausdehnungskoeffizienten hat als das Material der Targetplatte,
- flächiges Wirkverbinden der Targetplatte und der Rückplatte durch Löten mit einem Bonding-Lot bei einer Temperatur zwischen 400°C und 1000°C sowie Abkühlen des Targets um einen Targetplatten-Rückplattenverbund zu erzeugen, wobei das Bonding Lot einen Schmelzpunkt von größer 400°C aufweist.

Dabei weist der Werkstoff der Rückplatte, verglichen mit dem Werkstoff der Targetplatte, folgende Eigenschaften auf:
- Niedrigerer thermischer Ausdehnungskoeffizient
- Höhere Festigkeit (Streckgrenze bzw. 0,2 Dehngrenze bzw. Zugfestigkeit) Weiters weist der Werkstoff der Rückplatte in vorteilhaften Ausführungsformen folgende Eigenschaften verglichen mit dem Werkstoff der Targetplatte auf:
- Höherer Elastizitätsmodul
- Höhere Wärmeleitfähigkeit

Targetplatte und Rückplatte werden zur Herstellung des erfindungsgemäßen Sputtering Targets miteinander verbunden.

Das Bonding Lot ist dabei nur einige zehntel Millimeter dick und erfüllt die Funktion der Wärmeleitung und der mechanischen Verbindung der Targetplatte mit der Rückplatte. Die Targetplatte kann dabei eine einfache Form wie die einer Scheibe oder rechteckigen Platte annehmen.

Folgende Anforderungen an den Bonding-Prozess sind zu erfüllen:
- Vollflächige Benetzung des Bondmaterials (Bonding Lot) um eine homogene Temperaturverteilung an der Targetplatte zu ermöglichen. Bei nicht vollflächiger Benetzung ist der Wärmetransfer von der Targetplatte zur Rückplatte eingeschränkt, so dass das Sputtering Target stark erhitzt wird und somit auch das Bonding Lot hohe Temperatur erreicht. Beim Überschreiten des Schmelzpunktes des Bonding Lots kann dies dazu führen, dass die Targetplatte komplett von der Rückplatte getrennt wird. Bei inhomogener Temperaturverteilung kommt es zu thermisch induzierten mechanischen Spannungen welche zum Bruch (in diesem Fall Versagen durch Ablösen ausgebrochener Stücke) der Targetplatte führen können.
- Gute Wärmeleitfähigkeit des Bondmaterials
- Hohe Haftfestigkeit
- Hoher Schmelzpunkt des Bondmaterials um eine hohe Sputter Leistungsdichte anwenden zu können.

Heute üblich sind folgende Verfahren um eine spröde, insbesondere keramische Targetplatte auf eine Rückplatte zu bonden:

### 1. Indium Bonden (nicht erfindungsgemäß):

Vorteil: Sehr einfach anzuwenden, hohe thermische Leitfähigkeit des Indium Bonding Lotes
Nachteil: Die Schmelztemperatur von Indium beträgt 156°C, daher ist nur eine geringe Leistungsdichte des Sputterprozesses möglich.

### 2. AgSn (Silber-Zinn Lot) Bonden (nicht erfindungsgemäß):

Vorteil: etwas höherer Schmelzpunkt als jener von Indium von 220°C
Nachteil: schwieriger in der Anwendung, schwieriger in der Benetzung und vollflächigen Anwendung. Anwendung eventuell mit teurerem Verfahren "Nanofoil", geringere Wärmeleitfähigkeit

### 3. Kleben unter Anwendung von elektrisch und thermisch leitfähigen Klebern (nicht erfindungsgemäß):

Vorteil: Höhere Temperaturverträglichkeit
Nachteil: geringe Wärmeleitfähigkeit, dadurch höhere Temperatur des Targets beim Sputterprozess, was wiederum bei auf eine bestimmte Temperatur begrenzter thermischer Stabilität des Klebers zum Versagen der Verbindung führen kann.

Beim Indium Bonden ist beispielsweise durch den geringen Schmelzpunkt bei Verwendung von Indium Lot oder durch nicht vollflächige Benetzung des Bonding Lotes oder durch schlechte Wärmeleitfähigkeit des Bonding Lotes, verbunden mit den spröden Eigenschaften von keramischen Targetplatten, die anwendbare Sputter Leistungdichte auf ca. 5-10 W/cm2 limitiert. Die damit erreichbaren Beschichtungsraten sind dabei gering.

Die vorliegende Erfindung beschreibt ein Sputtering Target und eine Methode zu dessen Herstellung. Die spröde, insbesondere keramische Targetplatte soll mit der Rückplatte (back plate) hochtemperaturfest verbunden sein, wobei nach dem Bonding-Prozess durch thermische Fehlpassung aufgrund unterschiedlicher Ausdehnungskoeffizienten der Targetplatte und der Rückplatte feine Mikrorisse in der Targetplatte entstehen. Der thermische Ausdehnungskoeffizient der Targetplatte muss grösser als jener der Rückplatte sein.

Die Verbindung einer spröden, insbesondere keramischen Targetplatte mit einer Rückplatte soll durch ein Vakuum-Löt Verfahren (http://de.wikipedia.org/wiki/Vakuumlöten) bei hohen Temperaturen (auch "Hochtemperaturlöten") erfolgen. Der Vakuum-Löt Vorgang findet üblicherweise bei 400-1000°C statt.

Beim Hochtemperaturlöten sollen bevorzugt Lote verwendet werden, die einen Schmelzpunkt oberhalb von 400°C haben, bevorzugt oberhalb von 600°C und vorzugsweise oberhalb von 900°C und etwa bis zu 1200°C haben. Das Löt Verfahren findet zur Vermeidung von Schädigung durch Oxidation bevorzugt im Vakuum statt. Das Lot kann dabei in Form einer Lotfolie oder einer Lotpaste bereitgestellt werden. Beim Abkühlen von der Löttemperatur entstehen, bedingt durch den Unterschied der thermischen Ausdehnungskoeffizienten zwischen der Targetplatte und der Rückplatte, Zugspannungen in der Targetplatte, die zur Bildung von Mikrorissen führen. Dies geschieht unter der Bedingung, dass die durch den Abkühlvorgang in der Targetplatte entstehenden Zugspannungen die Streckgrenze des Werkstoffes der Targetplatte übersteigen und die daraus resultierenden Dehnungen nicht plastisch erfolgen können. Bedingung dafür ist außerdem eine fachgerechte, gute flächigen Anbindung der Targetplatte zur Rückplatte.

Das Hartlöten des Targets mit der Rückplatte kann drucklos in einem Vakuumofen erfolgen.

Ist zum Beispiel die Targetplatte aus TiB2 und die Rückplatte aus Molybdän, so wird sich nach dem Bonding-Prozess und Abkühlen des Sputtering Target (Verbund Targetplatte/Rückplatte) aufgrund der unterschiedlichen thermischen Ausdehnungskoeffizienten von TiB2 und Mo eine Zugspannung in der Targetplatte ausbilden.

Der Ausdehnungskoeffizient von TiB2 beträgt 8.1 µm/°C, jener von Molybdän 4.8µm/°C.

Optional kann das Sputtering Target nach dem Löt Verfahren gestrahlt (z.B. über Sandstrahlen) werden. Dieser Fertigungsschritt dient zum einen der Reinigung des Sputtering Targets von überschüssigem Lot, zum anderen kann dieser eine unterstützende Wirkung für die Bildung der Mikrorisse in der Targetplatte haben.

Durch den Aufprall des Strahlgutes (z.B. Sandstrahlen mit Korund Körnern) werden Spannungen in die Oberfläche der Targetplatte eingebracht und durch das fehlende Vermögen des Werkstoffes zur plastischen Deformation fein verteilte Mikrorisse gebildet. Es ist weiter möglich, dass durch das Auftreffen des Strahlguts zusätzlich Mikrorisse initiiert werden. Dabei werden gleichzeitig die in der Rückplatte nach dem Abkühlen von der Löttemperatur entstandenen elastischen Dehnungen abgebaut, weil die für die Spannungen verantwortliche Targetplatte wie oben beschrieben Mikrorisse ausbildet. Damit werden die Biegespannungen im Sputtering Target (Verbund Targetplatte/Rückplatte) reduziert.

Es ist weiter möglich, dass entsprechende Mikrorisse erst oder noch zusätzlich beim Einsatz des Sputtering Targets in einer Beschichtungsanlage, z.B. durch inhomogenen Wärmeeintrag gebildet werden.

Nach dem Einsatz des Sputtering Targets bzw. bis zum Erreichen der maximalen Lebensdauer kann die Targetplatte durch Erhitzen des Sputtering Targets auf Temperaturen oberhalb des Schmelzpunktes des Lotes von der Rückplatte getrennt werden, sodass die Rückplatte für ein neues Sputtering Target erneut eingesetzt werden kann.

Das durch ein erfindungsgemäßes Verfahren hergestellte Sputtering Target kann bei sehr hohen Sputter Leistungsdichten eingesetzt werden, da die Targetplatte mit der Rückplatte mit einem bis zu sehr hohen Temperaturen beständigen und gut wärmeleitfähigen Lot verbunden ist.

Das durch ein erfindungsgemäßes Verfahren hergestellte Sputtering Target ist unempfindlich gegen hohe Drücke die vom Kühlwassers auf die Rückseite des Sputtering Targets ausgeübt werden, da es mit einer Rückplatte versehen ist, die eine hohe Steifigkeit und eine hohe Festigkeit aufweist.

Das oben beschriebene Sputtering Target sowie auch der oben beschriebene Fertigungsweg kann zum Beispiel auch bei folgenden Werkstoffpaarungen (Targetplatte/Rückplatte) in besonders vorteilhafter Weise zur Anwendung kommen:
Targetplatte: Boride (z.B. TiB2, CrB2, WB), Karbide (z.B. WC, TiC, SiC), Nitride (z.B. TiN, AIN), Silizide (z.B. TiSi2, CrSi2), Oxide, Verbundwerkstoffe die Boride, Karbide, Nitride, Silizide, Oxide, Metalle (z.B. Mo, W, Ti, V, Zr) enthalten, elementare spröde Werkstoffe wie Si, Cr, Ge.
Rückplatte: Molybdän, Molybdänlegierungen, Molybdän Verbundwerkstoffe, Wolfram, Wolframlegierungen, Wolfram Verbundwerkstoffe.

### Figurenbeschreibung:

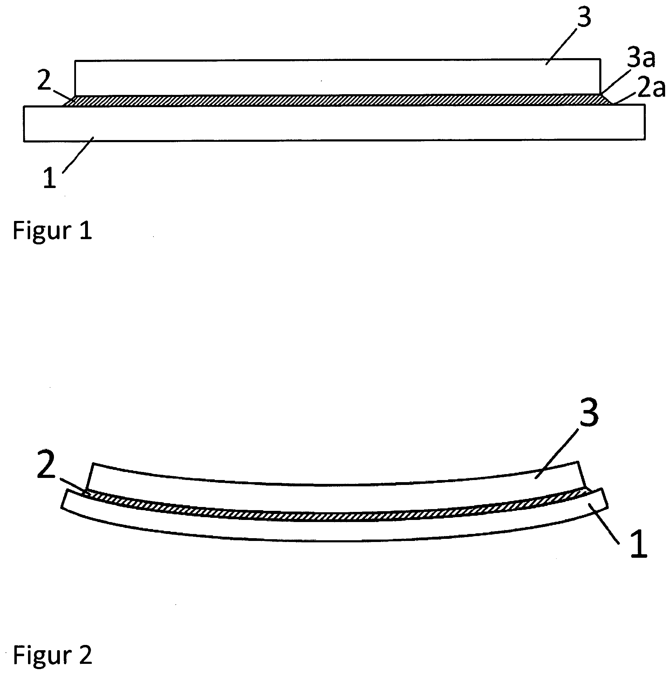

Figur 1: Sputtering Target (Verbund Targetplatte/Rückplatte) während des Vakuum-Löt Prozesses
   - 1: Rückplatte
   - 2: Bonding Lot
   - 3: spröde, insbesondere keramische Targetplatte
   - 2a: Kontaktfläche der Rückplatte
   - 3a: Kontaktfläche der Targetplatte
   Targetplatte (1) liegt auf der Rückplatte (3). Bei hohen Temperaturen schmilzt das Bonding Lot (2) und benetzt die Kontaktflächen 3a und 2a vollständig.
Figur 2: Sputtering Target (Verbund Targetplatte/Rückplatte) nach erfolgter Verbindung im Vakuum-Löt Prozess und anschließendem Abkühlen an Atmosphäre, bei Verwendung von TiB2 als Targetplatte (3) und Molybdän als Rückplatte (1)
   Durch den unterschiedlichen thermischen Ausdehnungskoeffizienten von TiB2 und Mo entstehen in der Targetplatte TiB2 Zugspannungen welche zu einer Krümmung des Sputtering Targets (Verbund Targetplatte/Rückplatte) führen (hier stark übertrieben gezeichnet).

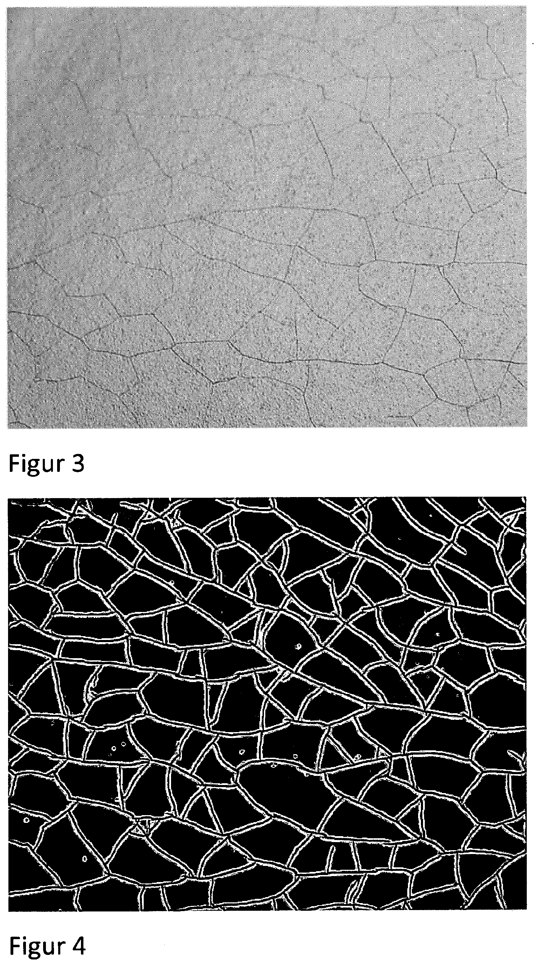

Figur 3: Target nach Löt Prozess und erstmaligem Sputtern; feine Mikrorisse überdecken das Target. Das Lot bleibt dabei intakt, das heißt, die thermische und mechanische Verbindung der Targetplatte zur Rückplatte ist hervorragend.
Figur 4: Oberfläche des TiB2 -Molybdän Sputtering Targets (Verbund Targetplatte/Rückplatte) nach einem Hochleistungs-Sputter-Test von 30 Stunden mit einer Leistungsdichte von 45 W/cm2.
   Konkret offenbart die vorliegende Erfindung auch ein Vakuumbeschichtungsverfahren, bei dem zumindest ein Target als Sputtering Target zur Beschichtung zumindest einer zu beschichtenden Oberfläche eines Substrates mittels Sputtern des Targets verwendet wird, wobei
   - das Target eine zu sputternde Targetplatte aus einem Material A mit Vorderseite und Rückseite und eine Rückplatte aus einem Material B mit einer der Targetplatte zugewandte Seite aufweist, wobei die der Targetplatte zugewandte Seite der Rückplatte mit der Rückseite der Targetplatte flächig mit Hilfe eines Materials C mechanisch stabil verbunden ist, wobei das Material C ein Bonding Lot mit einem Schmelzpunkt von größer 400°C ist,
   wobei
   - das Material A zumindest größtenteils aus einem oder mehreren spröden Werkstoffen besteht und zumindest als Hauptbestandteil ein keramisches Material umfasst und das Material B zumindest größtenteils aus einem oder mehreren Werkstoffen mit höherer Duktilität im Vergleich mit den spröden Werkstoffen im Material A besteht,
   - der Ausdehnungskoeffizient des Materials A grösser als der Ausdehnungskoeffizient des Materials B ist und das Material B eine höhere Duktilität und/oder Festigkeit als das Material A aufweist,
   - die Targetplatte zumindest bei Raumtemperatur unter Zugspannungen steht, dergestalt dass dies zur Entstehung von Mikrorissen führt, welche von der Vorderseite zur Rückseite durchgehen und die Targetplatte in aneinander grenzende Bruchstücke aufteilen, dergestalt dass während des Einbringens einer Sputterleistung zum Sputtern der Targetplatte, die Ränder der Bruchstücke sich relativ zueinander verschieben, so dass im Vergleich mit einem Target ohne Mikrorissen weniger Spannungen innerhalb der Targetplatte auftreten, und dadurch eine höhere Sputterleistung verwendet werden kann ohne dass die Targetplatte zerstört wird.

Das erfinderische Vakuumbeschichtungsverfahren kann insbesondere so ausgeführt werden, dass das Material A im Wesentlichen aus TiB2 besteht und das Material B im Wesentlichen aus Mo besteht und die Rückplatte mit der Targetplatte mittels Löten bei einer Temperatur zwischen 400°C und 1000°C verbunden ist.

Gemäß einer bevorzugten Ausführungsform wird das erfinderische Vakuumbeschichtungsverfahren so ausgeführt, dass die Beschichtung mittels Hochleistungsimpulsmagnetronsputtern (auch HIPIMS "High-power impulse magnetron sputtering" genannt) des Targets durchgeführt wird.

## Patentansprüche

1. Target, insbesondere Sputtering Target, umfassend eine Targetplatte aus einem spröden Werkstoff, und eine Rückplatte, die mit der Targetplatte flächig verbunden ist, wobei die Targetplatte eine der Rückplatte zugewandte Kontaktfläche aufweist und die Rückplatte eine der Targetplatte zugewandte Kontaktfläche aufweist, wobei zwischen der Kontaktfläche der Targetplatte und der Kontaktfläche der Rückplatte ein Bonding Lot vorliegt wobei die Targetplatte Mikrorisse aufweist, welche von der Vorderseite zur Rückseite der Targetplatte durchgehen und die Targetplatte in aneinander grenzende Bruchstücke aufteilt, **dadurch gekennzeichnet, dass** die Targetplatte zumindest als Hauptbestandteil ein keramisches Material umfasst, dass der thermische Ausdehnungskoeffizient der Targetplatte höher als jener der Rückplatte ist und dass das Bonding Lot einen Schmelzpunkt von größer 400°C aufweist.

2. Target nach Anspruch 1, **dadurch gekennzeichnet, dass** die Länge und Breite der Bruchstücke der Targetplatte im Mittel in der Größenordnung der Dicke der Targetplatte liegen.

3. Target, nach Anspruch 1 oder 2, **dadurch gekennzeichnet, dass** die Festigkeit der Targetplatte niedriger als jene der Rückplatte ist.

4. Verfahren zur Herstellung eines Targets, insbesondere eines Sputtering Targets, **dadurch gekennzeichnet, dass** es die folgenden Schritte umfasst:
- Bereitstellen einer Targetplatte, die zumindest als Hauptbestandteil ein keramisches Material umfasst
- Bereitstellen einer Rückplatte, wobei für die Rückplatte ein Material gewählt wird, welches einen kleineren thermischen Ausdehnungskoeffizienten hat als das Material der Targetplatte,
- Flächiges Wirkverbinden der Targetplatte und der Rückplatte durch Löten mit einem Bonding-Lot bei einer Temperatur zwischen 400°C und 1000°C sowie Abkühlen des Targets, um einen Targetplatten-Rückplattenverbund zu erzeugen, wobei das Bonding Lot einen Schmelzpunkt von größer 400°C aufweist.

5. Verfahren zur Herstellung eines Targets nach Anspruch 4, **dadurch gekennzeichnet, dass** es zusätzlich folgenden Schritt umfasst:
- Strahlen des Targets.

6. Vakuumbeschichtungsverfahren, bei dem zumindest ein Target als Sputtering Target zur Beschichtung zumindest einer zu beschichtenden Oberfläche eines Substrates mittels Sputtern des Targets verwendet wird, wobei
- das Target eine zu sputternde Targetplatte aus einem Material A mit Vorderseite und Rückseite und eine Rückplatte aus einem Material B mit einer der Targetplatte zugewandte Seite aufweist, wobei die der Targetplatte zugewandte Seite der Rückplatte mit der Rückseite der Targetplatte flächig mit Hilfe eines Materials C mechanisch stabil verbunden ist, wobei das Material C ein Bonding Lot mit einem Schmelzpunkt von größer 400°C ist,
**dadurch gekennzeichnet, dass**
- das Material A zumindest größtenteils aus einem oder mehreren spröden Werkstoffen besteht und zumindest als Hauptbestandteil ein keramisches Material umfasst und das Material B zumindest größtenteils aus einem oder mehreren Werkstoffen mit höherer Duktilität im Vergleich mit den spröden Werkstoffen im Material A besteht,
- der Ausdehnungskoeffizient des Materials A grösser als der Ausdehnungskoeffizient des Materials B ist und das Material B eine höhere Duktilität und/oder Festigkeit als das Material A aufweist,
- die Targetplatte zumindest bei Raumtemperatur unter Zugspannungen steht, dergestalt dass dies zur Entstehung von Mikrorissen führt, welche von der Vorderseite zur Rückseite durchgehen und die Targetplatte in aneinander grenzende Bruchstücke aufteilen, dergestalt dass während des Einbringens einer Sputterleistung zum Sputtern der Targetplatte, die Ränder der Bruchstücke sich relativ zueinander verschieben, so dass im Vergleich mit einem Target ohne Mikrorissen weniger Spannungen innerhalb der Targetplatte auftreten, und dadurch eine höhere Sputterleistung verwendet werden kann ohne dass die Targetplatte zerstört wird.

7. Vakuumbeschichtungsverfahren nach Anspruch 6, **dadurch gekennzeichnet, dass** das Material A im Wesentlichen aus TiB2 besteht und das Material B im Wesentlichen aus Mo besteht und die Rückplatte mit der Targetplatte mittels Löten bei einer Temperatur zwischen 400°C und 1000°C verbunden ist.

8. Vakuumbeschichtungsverfahren nach einem der Ansprüche 6 oder 7, **dadurch gekennzeichnet, dass** die Beschichtung mittels Hochleistungsimpulsmagnetronsputtern des Targets durchgeführt wird.

## Claims

1. A target, in particular a sputtering target, comprising a target plate composed of a brittle material, and a back plate which is bonded over an area to the target plate, where the target plate has a contact surface facing the back plate and the back plate has a contact surface facing the target plate, wherein a bonding solder is present between the contact surface of the target plate and the contact surface of the back plate, wherein the target plate has microcracks which go through from the front side to the rear side of the target plate and divide the target plate into adjoining fragments, **characterized in that** the target plate comprises at least a ceramic material as main constituent, the coefficient of thermal expansion of the target plate is higher than that of the back plate and **in that** the bonding solder has a melting point of greater than 400°C.

2. The target according to claim 1 wherein the length and width of the fragments of the target plate are on average in the order of magnitude of the thickness of the target plate.

3. The target according to claim 1 or 2, wherein the strength of the target plate is lower than that of the back plate.

4. A process for producing a target, in particular a sputtering target, which comprises the following steps:
- provision of a target plate comprising at least a brittle material as main constituent,
- provision of a back plate, wherein a material which has a smaller coefficient of thermal expansion than the material of the target plate is selected for the back plate,
- effective bonding over an area of the target plate and the back plate by soldering at a temperature in the range of 400°C to 1000°C, and cooling of the target in order to produce a target plate-back plate composite, wherein a solder having a melting point of greater than 400°C is used.

5. The process for producing a target as claimed in claim 4, wherein the process additionally comprises the following step:
- particle blasting of the target.

6. Vacuum coating process in which at least one target is used as a sputtering target for coating at least one surface of a substrate to be coated via sputtering of the target, whereas
- The target has a target plate to be sputtered composed of a material A having a front side and a rear side and the target has a back plate composed of a material B having a side facing the target plate, whereas the side of the back plate facing the target plate is mechanically stable bonded over an area to the rear side of the target plate by means of a material C, wherein the material C is a bonding solder having a melting point of greater than 400°C
whereas
- The material A is at least mainly composed of one or more brittle materials and comprises at least a ceramic material as main constituent and the material B is at least mainly composed of one or more materials having a higher ductility compared to the brittle materials of material A
- The coefficient of thermal expansion of the material A is higher than the coefficient of thermal expansion of the material B and the material B has a higher ductility and/or strength than the material A
- The target plate is under tensile stress at least at room temperature in such a way that this leads to the formation of microcracks which go through from the front side to the rear side of the target plate and divide the target plate into adjoining fragments, in such a way that during the introduction of a sputtering power in order to sputter the target plate the edges of the fragments move relative to each other, so that lower stresses occur inside the target plate compared to a target without microcracks and a higher sputtering power can be used without failure of the target plate.

7. Vacuum coating process according to Claim 6, where the material A is mainly composed of TiB₂ and the material B is mainly composed of Mo and the back plate is bonded to the target plate via soldering at a temperature of between 400°C and 1000°C.

8. Vacuum coating process according to Claim 6 or 7 where the deposition process is executed via high-power impulse magnetron sputtering (HIPIMS) of the target.

## Revendications

1. Cible, en particulier cible de pulvérisation cathodique, comprenant une plaque de cible en un matériau fragile, et une plaque de dossier, qui est assemblée à plat à la plaque de cible, dans laquelle la plaque de cible présente une face de contact tournée vers la plaque de dossier et la plaque de dossier présente une face de contact tournée vers la plaque de cible, dans laquelle il se trouve une brasure de liaison entre la face de contact de la plaque de cible et la face de contact de la plaque de dossier, dans laquelle la plaque de cible présente des microfissures, qui traversent du côté avant au côté arrière de la plaque de cible et qui partagent la plaque de cible en fragments adjacents l'un à l'autre, **caractérisée en ce que** la plaque de cible comprend au moins comme composant principal un matériau céramique, **en ce que** le coefficient de dilatation thermique de la plaque de cible est plus élevé que celui de la plaque de dossier et **en ce que** la brasure de liaison présente un point de fusion de plus de 400°C.

2. Cible selon la revendication 1, **caractérisée en ce que** la longueur et la largeur des fragments de la plaque de cible se situent en moyenne dans l'ordre de grandeur de l'épaisseur de la plaque de cible.

3. Cible selon la revendication 1 ou 2, **caractérisée en ce que** la résistance de la plaque de cible est inférieure à celle de la plaque de dossier.

4. Procédé de fabrication d'une cible, en particulier d'une cible de pulvérisation cathodique, **caractérisé en ce qu'**il comprend les étapes suivantes:
- préparer une plaque de cible, qui comprend au moins comme composant principal un matériau céramique,
- préparer une plaque de dossier, dans lequel on choisit pour la plaque de dossier un matériau, qui a un coefficient de dilatation thermique inférieur à celui du matériau de la plaque de cible,
- assembler activement à plat la plaque de cible et la plaque de dossier par brasage avec une brasure de liaison à une température comprise entre 400°C et 1000°C et refroidir la cible, pour produire un composite plaque de cible-plaque de dossier, dans lequel la brasure de liaison présente un point de fusion de plus de 400°C.

5. Procédé de fabrication d'une cible selon la revendication 4, **caractérisé en ce qu'**il comprend en outre l'étape suivante:
- irradier la cible.

6. Procédé de revêtement sous vide, dans lequel on utilise au moins une cible comme cible de pulvérisation cathodique pour le revêtement d'au moins une surface d'un substrat à revêtir par pulvérisation cathodique de la cible, dans lequel
- la cible présente une plaque de cible pour pulvérisation cathodique en un matériau A avec un côté avant et un côté arrière et une plaque de dossier en un matériau B avec un côté tourné vers la plaque de cible, dans lequel le côté de la plaque de dossier tourné vers la plaque de cible est assemblé à plat de façon mécaniquement stable au côté arrière de la plaque de cible au moyen d'un matériau C, dans lequel le matériau C est une brasure de liaison avec un point de fusion de plus de 400°C,
**caractérisé en ce que**
- le matériau A se compose au moins en majeure partie d'un ou de plusieurs matériau(x) fragile(s) et comprend au moins comme composant principal un matériau céramique et le matériau B se compose au moins en majeure partie d'un ou de plusieurs matériau(x) ayant une ductilité plus élevée par comparaison avec les matériaux fragiles dans le matériau A,
- le coefficient de dilatation du matériau A est plus élevé que le coefficient de dilatation du matériau B et le matériau B présente une ductilité et/ou une résistance plus élevée que le matériau A,
- la plaque de cible se trouve au moins à la température ambiante sous des contraintes de traction, de telle manière que ceci conduise à l'apparition de microfissures, qui traversent du côté avant au côté arrière et qui partagent la plaque de cible en fragments adjacents l'un à l'autre, de telle manière que pendant l'application d'une puissance de pulvérisation cathodique pour la pulvérisation cathodique de la plaque de cible les bords des fragments se déplacent l'un par rapport à l'autre, de telle manière que par comparaison avec une cible sans microfissures il apparaisse moins de contraintes à l'intérieur de la plaque de cible, et que l'on puisse ainsi utiliser une puissance de pulvérisation cathodique plus élevée sans que la plaque de cible soit détruite.

7. Procédé de revêtement sous vide selon la revendication 6, **caractérisé en ce que** le matériau A se compose essentiellement de TiB₂ et le matériau B se compose essentiellement de Mo et la plaque de dossier est assemblée à la plaque de cible par brasage à une température comprise entre 400°C et 1000°C.

8. Procédé de revêtement sous vide selon une des revendications 6 ou 7, **caractérisé en ce que** l'on effectue le revêtement par pulvérisation cathodique magnétron à impulsions de haute puissance de la cible.
